# EUROPEAN PATENT APPLICATION

(11) **EP 1 684 335 A1**
(43) Date of publication of application: **26.07.2006**
(21) Application number: 04772140.2
(22) Date of filing: 25.08.2004
(51) Int. Cl.: H01L 21/205

(54) **PROCESS FOR PRODUCING SILICON EPITAXIAL WAFER**

(30) Priority: 14.11.2003 JP 2003385333
(71) Applicant: Shin-Etsu Handotai Co., Ltd, Tokyo 100-0005 (JP)
(72) Inventor: TAKAMIZAWA, Syo-ichi c/o Shin-Etsu Handotai Co.,, Annaka-shi, Gunma 3790196 (JP); SAYAMA, Ryuji c/o Shin-Etsu Handotai Co., Ltd., Annaka-shi, Gunma 3790196 (JP)
(74) Representative: Jones, Helen M.M.
(86) International application number: PCT/JP2004/012179
(87) International publication number: WO 2005/048331

(57) **Abstract**

For a silicon single crystal substrate PW to which boron, arsenic or phosphorus is added as a dopant in a concentration of 1×10¹⁹ /cm³ or more and in which a CVD oxide film 1 is formed on a rear surface, wet etching of an oxide film on a main surface of the silicon single crystal substrate PW is performed by a hydrofluoric acid treatment while the CVD oxide film 1 is allowed to remain (step S5). Next, the silicon single crystal substrate PW is baked at 950°C or less in a hydrogen gas to perform dry etching of a natural oxide film on the main surface of the silicon single crystal substrate PW (step S7). Further, a sub-epitaxial layer 2 is formed at a temperature lower than a growth temperature of a main epitaxial layer 3 (step S8) and the main epitaxial layer 3 is formed on the sub-epitaxial layer 2 at a temperature of 900 to 1200°C (step S9) .

## Description

### Technical Field

The present invention relates to a method for producing a silicon epitaxial wafer, for forming a silicon epitaxial layer on a main surface of a silicon single crystal substrate.

### Background Art

A method for forming a silicon epitaxial layer on a main surface of a silicon single crystal substrate includes a vapor phase epitaxial growth method. The vapor phase epitaxial growth method is a method for supplying a raw material gas onto the main surface of the silicon single crystal substrate to grow a single-crystal thin film having the same plane orientation as that of the silicon single crystal substrate, namely, a silicon epitaxial layer.

When such a vapor phase epitaxial growth method is used to form a high-resistivity silicon epitaxial layer on a main surface of a low-resistivity silicon single crystal substrate having concentrated boron, arsenic or phosphorus as a dopant, a phenomenon that dopants are once discharged into a vapor phase from the silicon single crystal substrate and doped in the growing silicon epitaxial layer, what is called, an auto-doping phenomenon occurs and as a result, an impurity profile may become gentle in the interface between the silicon single crystal substrate and the silicon epitaxial layer.

The reason why the auto-doping phenomenon occurs during vapor phase growth of a lowly-doped silicon epitaxial layer on a highly-doped silicon single crystal substrate, in other words, during vapor phase growth of a high-resistivity silicon epitaxial layer having the same conductivity type as that of the substrate on a low-resistivity silicon single crystal substrate is that dopants are discharged from the main surface or rear surface of the silicon single crystal substrate and retaken in the silicon epitaxial layer during the vapor phase growth. The dopants discharged from the rear surface of the silicon single crystal substrate penetrates into a main surface side from a peripheral part of the silicon single crystal substrate and therefore, an influence of the auto-doping phenomenon becomes remarkable in a periphery of the silicon epitaxial layer.

In the vapor phase growth of the silicon epitaxial layer, in order to suppress the auto-doping phenomenon due to a discharge of dopants from the main surface of the silicon single crystal substrate, a cap layer (sub-epitaxial layer) may be previously formed at a low temperature without externally supplying a dopant gas before forming a main epitaxial layer on the main surface of the silicon single crystal substrate (see, e.g., Patent Documents 1 and 2).

Herein, in order to suppress the auto-doping phenomenon, the forming temperature of the cap layer is preferably a lower temperature. Further, in order to perform the vapor phase growth of the cap layer while the silicon single crystal substrate is heated to a low temperature of lower than 1000°C, for example, from 500 to 850°C to keep a high crystal condition, a treatment by hydrofluoric acid-containing vapor must be previously performed within a main-chamber or sub-chamber to remove a natural oxide film formed on the main surface of the silicon single crystal substrate as described in Patent Document 2.

On the other hand, in order to suppress the discharge of dopants from the rear surface of the silicon single crystal substrate, a silicon oxide film for auto-doping prevention may be previously formed on the rear surface of the silicon single crystal substrate.
Patent Document 1: Japanese Patent Application Publication Unexamined Tokukaisho-58-041799
Patent Document 2: Japanese Patent Application Publication Unexamined Tokukaihei-09-120947

### Disclosure of the Invention

### Problem to be solved by the Invention

However, the silicon oxide film is etched by a hydrofluoric acid treatment and therefore, when low-temperature cap layer growing which requires the hydrofluoric acid treatment, is performed, no silicon oxide film for auto-doping prevention is conventionally applied to the silicon single crystal substrate. Therefore, it is difficult to perform vapor phase growth of a silicon epitaxial layer with a precipitous impurity concentration profile on the main surface of the silicon single crystal substrate highly doped with dopants.

The present invention has been made in order to solve the above-described problems and the object of the present invention is to provide a method for producing a silicon epitaxial wafer, which is capable of performing vapor phase growth of a silicon epitaxial layer with a more precipitous impurity concentration profile on a main surface of a silicon single crystal substrate.

### Means for Solving the Problems

A first method for producing a silicon epitaxial wafer of the present invention comprises the steps of:
a sub-epitaxial layer forming step of forming a sub-epitaxial layer on a main surface of a silicon single crystal substrate to which boron, arsenic or phosphorus is added as a dopant, and
a main epitaxial layer forming step of forming a main epitaxial layer on the sub-epitaxial layer, the sub-epitaxial layer forming step and the main epitaxial layer forming step being performed in this order to form a silicon epitaxial layer having the main epitaxial layer and the sub-epitaxial layer on the main surface of the silicon single crystal substrate,
wherein as the silicon single crystal substrate, a substrate having a rear surface on which a silicon oxide film for auto-doping prevention is formed, is used, and
a hydrofluoric acid treating step of dipping the silicon single crystal substrate in a hydrofluoric acid to perform wet etching of an oxide film formed on the main surface of the silicon single crystal substrate while the silicon oxide film for auto-doping prevention is allowed to remain, and
a baking step of performing dry etching of a natural oxide film formed on the main surface of the silicon single crystal substrate in a hydrogen gas atmosphere while the silicon single crystal substrate is heated to a temperature lower than a growth temperature of the main epitaxial layer, are performed in this order and then the sub-epitaxial layer forming step is performed.

According to the present invention, in the hydrofluoric acid treating step, the wet etching of the oxide film formed on the main surface of the silicon single crystal substrate is performed while the silicon oxide film for auto-doping prevention is allowed to remain and therefore, also when a low temperature cap layer growing which requires a hydrofluoric acid treatment, is performed, the silicon oxide film can be applied for auto-doping prevention. Accordingly, the vapor phase growth of the silicon epitaxial layer with a precipitous impurity concentration profile can be performed on the main surface of the silicon single crystal substrate.
However, when the silicon single crystal substrate is exposed to air between the hydrofluoric acid treating step and the sub-epitaxial layer forming step, a natural oxide film is formed and therefore, the baking step is further performed in a hydrogen gas atmosphere to perform dry etching of the natural oxide film formed on the main surface of the silicon single crystal substrate. On this occasion, in order to suppress occurrence of a useless auto-doping phenomenon, the baking step is performed while the silicon single crystal substrate is heated to a temperature lower than a growth temperature of the main epitaxial layer, for example, to a temperature of 950°C or less. When the silicon single crystal substrate is heated to a temperature higher than 950°C during the baking step, the auto-doping phenomenon increases nonnegligibly.

The sub-epitaxial layer may be formed, for example, to a thickness of less than 0.5 µm so as to suppress an auto-doping from the main surface of the silicon single crystal substrate. On the other hand, when the thickness of the sub-epitaxial layer is 0.5 µm or more, the thickness of the sub-epitaxial layer may be larger than an outward diffusion width of dopants from the silicon single crystal substrate, and as a result, the existence of the sub-epitaxial layer becomes obvious to exert an influence on characteristics of silicon epitaxial wafers.
However, the silicon single crystal substrate and the sub-epitaxial layer are hardly discriminated due to the outward diffusion of dopants from the silicon single crystal substrate, which occurs during a series of heat treatments performed after growing of the sub-epitaxial layer, and therefore, accuracy of a thickness and resistivity of the sub-epitaxial layer is rarely demanded. Therefore, when the sub-epitaxial layer forming step is performed while a temperature of the silicon single crystal substrate of which the thickness and resistivity are changeable, is raised, productivity of silicon epitaxial wafers can be enhanced.

It is preferred that the time of exposing the silicon single crystal substrate to air between the hydrofluoric acid treating step and the baking step is within 60 minutes. The thickness of the natural oxide film formed on the surface of the silicon single crystal substrate during this time is slight. Therefore, for example, when the baking step is performed in a hydrogen gas atmosphere while the silicon single crystal substrate is heated to 900°C, the natural oxide film is instantaneously removed by etching.
On the other hand, when the time of exposing the silicon single crystal substrate to air exceeds 60 minutes, it is necessary to lengthen the time of the baking step or to raise the baking temperature of the silicon single crystal substrate to more than 950°C in order to remove by etching a natural oxide film. Any method increases an influence of an auto-doping phenomenon and therefore, is not preferred.

When the sub-epitaxial layer is previously formed as described above, even if the main epitaxial layer is formed on the sub-epitaxial layer while the silicon single crystal substrate is heated to a temperature of 900 to 1200°C, silicon epitaxial wafers can be produced in a state where an auto-doping phenomenon is suppressed.
On the other hand, when the silicon single crystal substrate is heated to a temperature more than 1200°C to perform the vapor phase growth of the main epitaxial layer, there is some possibility that the amount of dopants diffused outward through the sub-epitaxial layer or the silicon oxide film for auto-doping prevention remarkably increases, and as a result, an auto-doping phenomenon can be no longer suppressed. Further, when the silicon single crystal substrate is heated to a temperature of less than 900°C to perform the vapor phase growth of the main epitaxial layer, the amount of dopants discharged from the substrate is directly suppressed, and therefore, the meaning of applying the present invention is reduced.

The auto-doping phenomenon easily becomes obvious particularly when resistivity of the main surface of the main epitaxial layer is set to not less than 20 times that of the silicon single crystal substrate, more specifically, when the silicon single crystal substrate with a dopant concentration of 1×10¹⁹ /cm³ or more is used. Accordingly, when the above-described sub-epitaxial layer is previously formed and the vapor phase growth of the main epitaxial layer with the main surface having the resistivity which is not less than 20 times that of the silicon single crystal substrate, is performed on the sub-epitaxial layer in the main epitaxial layer forming step, a dramatic effect is obtained on suppression of an auto-doping phenomenon.

A second method for producing a silicon epitaxial wafer of the present invention, comprises the steps of: using a silicon single crystal substrate to which boron, arsenic or phosphorus is added as a dopant in a concentration of 1×10¹⁹ /cm³ or more, the silicon single crystal substrate having a rear surface on which a silicon oxide film for auto-doping prevention is formed,
a hydrofluoric acid treating step of dipping the silicon single crystal substrate in a hydrofluoric acid to perform wet etching of an oxide film formed on a main surface of the silicon single crystal substrate while the silicon oxide film for auto-doping prevention is allowed to remain,
a baking step of inputting the silicon single crystal substrate into a vapor phase growth apparatus after the hydrofluoric acid treating step while a time of exposing the silicon single crystal substrate to air is set within 60 minutes, and performing dry etching of a natural oxide film formed on the main surface of the silicon single crystal substrate in a hydrogen gas atmosphere while the silicon single crystal substrate is heated to a temperature of 950°C or less,
a sub-epitaxial layer forming step of performing a vapor phase growth of a sub-epitaxial layer having a thickness of less than 0.5 µm on the main surface of the silicon single crystal substrate while a temperature of the silicon single crystal substrate is raised toward a vapor phase growth temperature of a main epitaxial layer immediately after the baking step is finished, and
a main epitaxial layer forming step of performing a vapor phase growth of the main epitaxial layer with the main surface having resistivity which is not less than 20 times that of the silicon single crystal substrate, on the sub-epitaxial layer.

### Effect of the Invention

According to the present invention, vapor phase growth of a silicon epitaxial layer can be performed with a more precipitous impurity profile on a main surface of a silicon single crystal substrate.

### Brief Description of the Drawings

[FIG. 1] FIG. 1 shows production steps of a silicon epitaxial wafer in the present embodiment and sectional views of a silicon single crystal substrate and the like in respective steps.
[FIG. 2] FIG. 2 shows a dopant profile in a case of using a method for producing a silicon epitaxial wafer according to the present invention and a dopant profile in a case of using a conventional method for producing a silicon epitaxial wafer.

### Best Mode for Carrying Out the Invention

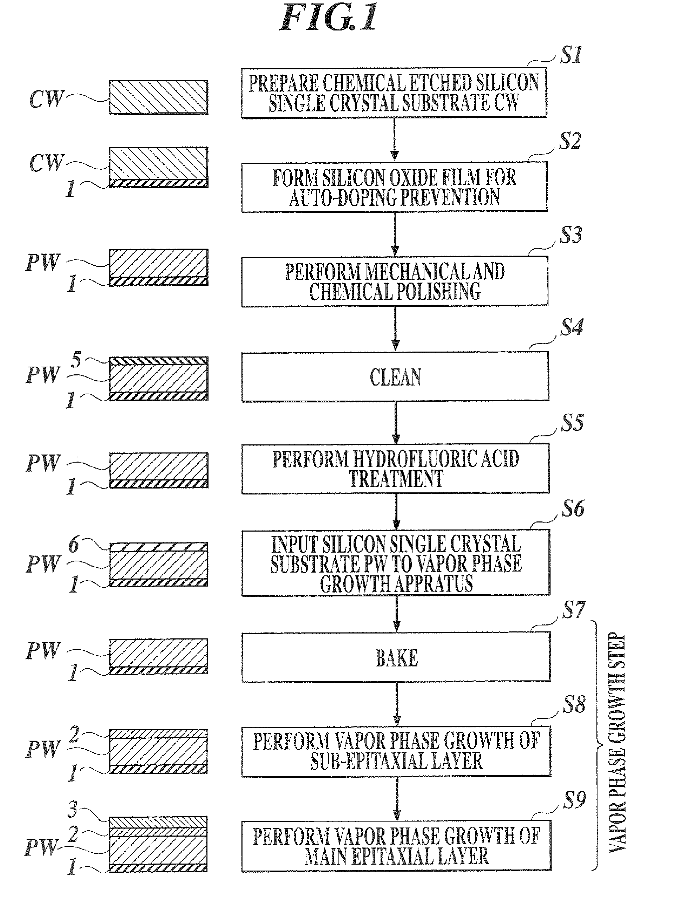

Embodiments of the present invention will be described below with reference to the accompanying drawings. Production steps of a silicon epitaxial wafer according to the embodiment of the present invention are shown on the right side of FIG.1 and sectional views of a silicon single crystal substrate CW corresponding to respective steps are shown on the left side of FIG.1.
First, a silicon single crystal ingot to which boron, arsenic or phosphorus is added as a dopant in a concentration of 1×10¹⁹ /cm³ or more is pulled up by a CZ (Czochralski) method and further, is subjected to processes such as block cutting, external diameter grinding, orientation flat machining, slicing, chamfering, lapping and chemical etching, to prepare the chemical etched silicon single crystal substrate CW (step S1).

Next, by using a CVD (Chemical Vapor Deposition) method, a silicon oxide film 1 for auto-doping prevention (hereinafter, simply referred to as a CVD oxide film) is formed on a second main surface (lower side surface in FIG.1) of the silicon single crystal substrate CW (step S2).
More specifically, onto the second main surface of the silicon single crystal substrate CW heated to from 350 to 450°C, a monosilane (SiH₄) gas and an oxygen gas are supplied as a raw material gas to perform vapor phase growth of a CVD oxide film 1 with a thickness of about 500 nm.

After the formation of the CVD oxide film 1, mechanical and chemical polishing is performed on a first main surface opposite to a surface on which the CVD oxide film 1 is formed (step S3) to form a silicon single crystal substrate PW having the first mirror-like main surface. On the silicon single crystal substrate PW, cleaning using SC-1 (ammonia-hydrogen peroxide solution) cleaning and SC-2 (hydrochloric acid-hydrogen peroxide solution) cleaning is performed to remove organic matters, metals or particles adhered to a surface of the substrate PW (step S4).

During the SC-1 cleaning or the SC-2 cleaning, a silicon oxide film is formed on a surface of the silicon single crystal substrate PW due to the oxygen behavior of the cleaning. Further, when the time of storing the substrate PW in air between the cleaning step and the vapor phase epitaxial growth step is long, a natural oxide film with a thickness unable to be removed by a low temperature heat treatment at 950°C or less may be formed. When the oxide films 5 remains during formation of a sub-epitaxial layer 2 grown at a low temperature in a post-process, the oxide films 5 exert a harmful influence on the crystallinity of the sub-epitaxial layer 2. Therefore, a hydrofluoric acid treating step of performing wet etching of the oxide films 5 by using a hydrofluoric acid is performed between the cleaning step and the vapor phase growth step to remove the oxide films 5 formed on the surface of the silicon single crystal substrate PW (step S5).
However, also the CVD oxide film 1 formed for auto-doping prevention on the second main surface of the silicon single crystal substrate PW is removed by etching using the hydrofluoric acid treatment. Therefore, a dilute hydrofluoric acid with a concentration of about 1% is used and the time of dipping the silicon single crystal substrate PW in the dilute hydrofluoric acid is shortened to about one minute. Therefore, the oxide films 5 are removed by wet etching while the CVD oxide film 1 is allowed to remain. Since the thickness of the silicon oxide film removed by etching during this time is about 6 nm, the oxide films 5 with a thickness of about 1 to 2 nm are entirely removed whereas the CVD oxide film 1 with a thickness of about 500 nm remains.
After the hydrofluoric acid treatment, only a pure water rinse and drying are performed and a cleaning with an oxygen behavior is not performed.

After removing the oxide films 5 on the surface of the silicon single crystal substrate PW, the silicon single crystal substrate PW is inputted into a vapor phase growth apparatus without being exposed to air for 60 minutes or more to suppress re-formation of the natural oxide film 6 (step S6). After the inputting into the vapor phase growth apparatus, the silicon single crystal substrate PW is placed in a non-oxidizing atmosphere and therefore, the natural oxide film 6 is prevented from being formed thereafter.
When the vapor phase growth apparatus where the substrate PW is inputted is pancake-shaped or barrel-type (cylinder-type), the silicon single crystal substrate PW is directly placed on a susceptor within a vapor phase growth furnace. Further, an air within the vapor phase growth furnace is replaced by nitrogen and then, nitrogen is further replaced by hydrogen. Thereafter, the vapor phase growth step is performed in a hydrogen atmosphere.
When the vapor phase growth apparatus where the substrate PW is inputted is a single wafer type, the silicon single crystal substrate PW is once stored within a load lock chamber maintained in a nitrogen atmosphere and then, conveyed within a vapor phase growth furnace maintained in a hydrogen atmosphere. Thereafter, the vapor phase growth step is performed in a hydrogen atmosphere.

The temperature of the silicon single crystal substrate PW placed in the vapor phase growth furnace is raised in a hydrogen atmosphere and the substrate PW is baked only for 5 minutes or less (e.g., for 1 to 2 minutes) at a temperature of 950°C or less (e.g., 900°C) (step S7). As a result, the natural oxide film 6 reproduced on the main surface of the silicon single crystal substrate PW between the hydrofluoric acid treatment and the inputting into the vapor phase growth apparatus is removed by dry etching.
As described above, the natural oxide film 6 formed on the surface of the silicon single crystal substrate PW is previously removed by wet etching using a hydrofluoric acid treatment and in a state where reproduction of the natural oxide film 6 is prevented as much as possible, the silicon single crystal substrate PW is inputted into the vapor phase growth appratus. Therefore, also when dry etching is performed by hydrogen baking under a relatively low temperature condition of lower than 1050°C such as 950°C or less which is regarded as a temperature necessary for SiO₂ to be reduced by H₂ to vaporize as SiO, the natural oxide film 6 reproduced on the silicon single crystal substrate PW can be entirely removed. Accordingly, outward diffusion of dopants from the silicon single crystal substrate PW into vapor phase, which causes an auto-doping phenomenon, can be suppressed. Further, since the natural oxide film 6 is entirely removed, vapor phase growth of an epitaxial layer having high crystallinity can be performed even under a relatively low temperature condition of from 700 to 950°C. Therefore, during growing of the sub-epitaxial layer 2 and the main epitaxial layer 3 after the next stage of the process, an auto-doping phenomenon can be suppressed while high crystallinity can be kept and as a result, vapor phase growth of a silicon epitaxial layer with a precipitous impurity profile can be performed.

Immediately after the completion of hydrogen baking, a raw material gas (e.g., SiH₂Cl₂, SiHCl₃ or SiH₄) is supplied onto the silicon single crystal substrate PW together with hydrogen as a carrier gas and thereby, the vapor phase growth of the sub-epitaxial layer 2 is performed on a first main surface of the silicon single crystal substrate PW to cover the first main surface of the silicon single crystal substrate PW. Thus, an auto-doping phenomenon from the main surface of the silicon single crystal substrate PW is suppressed (step S8).
Conventionally, the vapor phase growth of the sub-epitaxial layer 2 is performed after the hydrogen baking is performed under a high temperature condition. Therefore, in order to suppress an auto-doping phenomenon, the temperature must be once lowered to purge dopants discharged into vapor phase from the silicon single crystal substrate PW during the hydrogen baking. However, in the present embodiment, since the hydrogen baking is performed under a relatively low temperature condition, dopants are scarcely discharged into vapor phase. Therefore, even if the vapor phase growth of the sub-epitaxial layer 2 is performed immediately after the hydrogen baking, development of an auto-doping phenomenon can be held at the lowest level inevitably caused at a starting temperature of the vapor phase growth.

The formation of the sub-epitaxial layer 2 is performed by vapor phase growth of an epitaxial layer having a thickness of less than 0.5 µm, for example, 0.2 µm until reaching a predetermined temperature (e.g., 1000°C) while raising a temperature of the silicon single crystal substrate PW toward a vapor phase growth temperature of the main epitaxial layer immediately after the completion of the hydrogen baking. When thus forming the thickness of the sub-epitaxial layer 2 to be less than 0.5 µm, more preferably, further forming the thickness of the sub-epitaxial layer 2 to be one tenth or less the thickness of the main epitaxial layer 3, it can be prevented that the thickness of the sub-epitaxial layer 2 increases more than the outward diffusion width of dopants from the silicon single crystal substrate PW, and therefore, the sub-epitaxial layer 2 is prevented from becoming obvious, so that a precipitous dopant profile can be realized in an interface between the silicon single crystal substrate PW and the epitaxial layer.

After the formation of the sub-epitaxial layer 2, the vapor phase growth of the main epitaxial layer 3 having the same conductivity type as that of the silicon single crystal substrate PW is performed on the surface of the sub-epitaxial layer 2 (step S9). More specifically, the silicon single crystal substrate PW is heated to a temperature of 900 to 1200°C (e.g., about 1130°C) and onto the main surface of the sub-epitaxial layer 2, a raw material gas (e.g., SiH₂Cl₂, SiHCl₃ or SiH₄) and a dopant gas are supplied together with a carrier gas to form the main epitaxial layer 3 with the main surface having 20 times or more the resistivity of the silicon single crystal substrate PW.
During the vapor phase growth of the main epitaxial layer 3, the first main surface of the silicon single crystal substrate PW is covered with the sub-epitaxial layer 2 and the second main surface thereof is covered with the CVD oxide film 1. Further, dopants are scarcely discharged into vapor phase from the silicon single crystal substrate PW during the former heat treatment in the baking step (step S7) and the like. Therefore, the vapor phase growth of the main epitaxial layer 3 with a more precipitous impurity profile can be performed on the first main surface of the silicon single crystal substrate PW.

### [Example 1]

The present invention will be described in more detail below with reference to Example and Comparative Example.

### <Example>

In Example, a silicon epitaxial layer was formed on a main surface of the silicon single crystal substrate PW according to the method for producing a silicon epitaxial wafer in the above-described embodiment. For the silicon single crystal substrate PW, a substrate to which arsenic was added in a concentration of 2×10¹⁹ /cm³ and in which resistivity is about 3.5 mΩ was used. Further, in the baking step in step S7, the silicon single crystal substrate PW was heated at 900°C. Further, the thickness of the sub-epitaxial layer was formed to be 0.08 µm. Further, the forming temperature of the main epitaxial layer was set to 1130°C and the thickness of the whole silicon epitaxial layer was formed to be 1.2 µm.

### comparative Example>

Comparative Example was performed under the same condition as that in Example except for raising the temperature of the silicon single crystal substrate PW to 1150°C to perform the baking step.

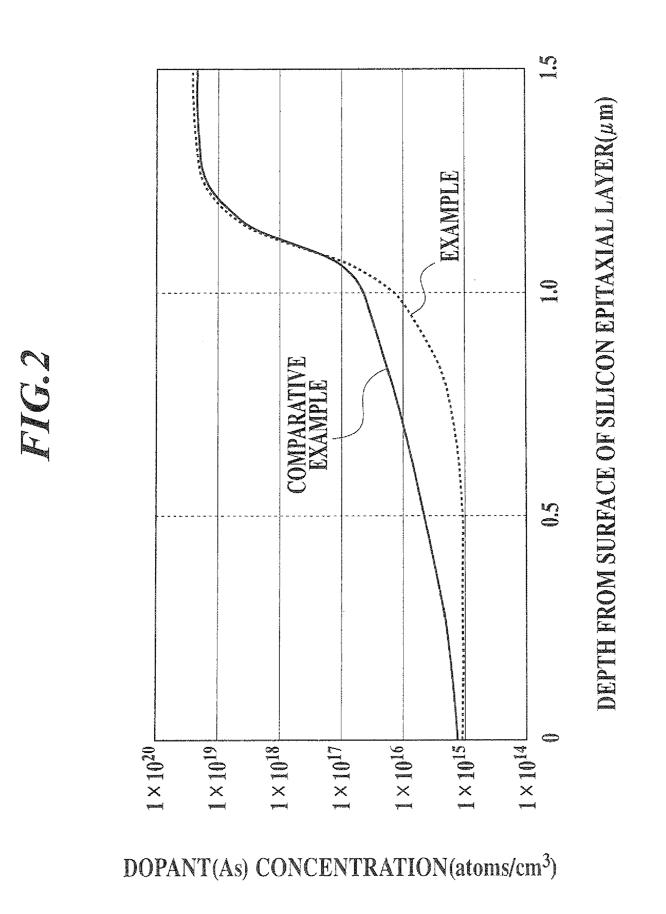

FIG.2 shows results obtained by forming the silicon epitaxial layers according to the methods for producing the silicon epitaxial wafer in the above-described Example and Comparative Example.
As shown in FIG.2, in Comparative Example, an influence of an auto-doping was serious and a dopant concentration was not made constant up to near the surface of the silicon epitaxial layer whereas in Example, a region with a flat dopant concentration was obtained from the silicon epitaxial layer surface to a depth of 0.6 µm or more.
From the results, it is understood that according to the method for producing a silicon epitaxial wafer of the present invention, a silicon epitaxial layer with a more precipitous dopant profile can be formed.

### Industrial Applicability

As described above, the method for producing a silicon epitaxial wafer according to the present invention is useful for the vapor phase growth of the silicon epitaxial layer with a more precipitous impurity concentration profile on the main surface of the silicon single crystal substrate and is particularly suitable for the vapor phase growth of the silicon epitaxial layer on the main surface of the silicon single crystal substrate with low resistivity.

### Explanation of Reference Numerals

- 1: silicon oxide film for auto-doping prevention
- 2: sub-epitaxial layer
- 3: main epitaxial layer
- PW, CW: silicon single crystal substrate

## Claims

1. A method for producing a silicon epitaxial wafer, comprising the steps of:
a sub-epitaxial layer forming step of forming a sub-epitaxial layer on a main surface of a silicon single crystal substrate to which boron, arsenic or phosphorus is added as a dopant, and
a main epitaxial layer forming step of forming a main epitaxial layer on the sub-epitaxial layer, the sub-epitaxial layer forming step and the main epitaxial layer forming step being performed in this order to form a silicon epitaxial layer having the main epitaxial layer and the sub-epitaxial layer on the main surface of the silicon single crystal substrate,
wherein as the silicon single crystal substrate, a substrate having a rear surface on which a silicon oxide film for auto-doping prevention is formed, is used, and
a hydrofluoric acid treating step of dipping the silicon single crystal substrate in a hydrofluoric acid to perform wet etching of an oxide film formed on the main surface of the silicon single crystal substrate while the silicon oxide film for auto-doping prevention is allowed to remain, and
a baking step of performing dry etching of a natural oxide film formed on the main surface of the silicon single crystal substrate in a hydrogen gas atmosphere while the silicon single crystal substrate is heated to a temperature lower than a growth temperature of the main epitaxial layer, are performed in this order and then the sub-epitaxial layer forming step is performed.

2. The method as claimed in claim 1, wherein the baking step is performed while the silicon single crystal substrate is heated to a temperature of 950°C or less.

3. The method as claimed in claim 1 or 2, wherein a thickness of the sub-epitaxial layer is formed to be less than 0.5 µm.

4. The method as claimed in any one of claims 1 to 3, wherein the sub-epitaxial layer forming step is performed while a temperature of the silicon single crystal substrate is raised.

5. The method as claimed in any one of claims 1 to 4, wherein a time of exposing the silicon single crystal substrate to air between the hydrofluoric acid treating step and the baking step is set within 60 minutes.

6. The method as claimed in any one of claims 1 to 5, wherein the main epitaxial layer forming step is performed while the silicon single crystal substrate is heated to a temperature of 900 to 1200°C.

7. The method as claimed in any one of claims 1 to 6, wherein resistivity of the main surface of the main epitaxial layer is set to not less than 20 times that of the silicon single crystal substrate.

8. The method as claimed in any one of claims 1 to 7, wherein a substrate having a dopant concentration of 1×10¹⁹ /cm³ or more is used as the silicon single crystal substrate.

9. A method for producing a silicon epitaxial wafer, comprising the steps of: using a silicon single crystal substrate to which boron, arsenic or phosphorus is added as a dopant in a concentration of 1×10¹⁹ /cm³ or more, the silicon single crystal substrate having a rear surface on which a silicon oxide film for auto-doping prevention is formed,
a hydrofluoric acid treating step of dipping the silicon single crystal substrate in a hydrofluoric acid to perform wet etching of an oxide film formed on a main surface of the silicon single crystal substrate while the silicon oxide film for auto-doping prevention is allowed to remain,
a baking step of inputting the silicon single crystal substrate into a vapor phase growth apparatus after the hydrofluoric acid treating step while a time of exposing the silicon single crystal substrate to air is set within 60 minutes, and performing dry etching of a natural oxide film formed on the main surface of the silicon single crystal substrate in a hydrogen gas atmosphere while the silicon single crystal substrate is heated to a temperature of 950°C or less,
a sub-epitaxial layer forming step of performing a vapor phase growth of a sub-epitaxial layer having a thickness of less than 0.5 µm on the main surface of the silicon single crystal substrate while a temperature of the silicon single crystal substrate is raised toward a vapor phase growth temperature of a main epitaxial layer immediately after the baking step is finished, and
a main epitaxial layer forming step of performing a vapor phase growth of the main epitaxial layer with the main surface having resistivity which is not less than 20 times that of the silicon single crystal substrate, on the sub-epitaxial layer.
